# EUROPÄISCHE PATENTSCHRIFT

(11) **EP 1 376 872 B1**
(45) Veröffentlichungstag und Bekanntmachung des Hinweises auf die Patenterteilung: **10.10.2007**
(21) Anmeldenummer: 03008971.8
(22) Anmeldetag: 17.04.2003
(51) Int. Cl.: H03K 17/96

(54) **Beleuchtungseinrichtung für Schaltflächen**
Illumination device for touchscreens
Dispositif d'éclairage pour des écrans sensibles à toucher

(30) Priorität: 07.05.2002 DE 10220268; 18.12.2002 DE 10259297
(43) Veröffentlichungstag der Anmeldung: 02.01.2004
(73) Patentinhaber: Schott AG, 55122 Mainz (DE)
(72) Erfinder: Engelmann, Harry, 55218 Ingelheim (DE)
(74) Vertreter: nospat Patentanwälte

(56) Entgegenhaltungen:
- EP-A- 0 759 660
- EP-A- 1 030 208
- EP-A- 1 154 573
- DE-A1- 19 914 304
- US-A- 5 975 711
- US-A- 2002 149 572
- US-B1- 6 290 364
- ANONYMOUS: "Fiber Optic Illuminated Switch. July 1975." IBM TECHNICAL DISCLOSURE BULLETIN, Bd. 18, Nr. 2, 1. Juli 1975 (1975-07-01), Seite 483, XP002384036 New York, US

## Beschreibung

Die Erfindung betrifft eine Einrichtung zur Beleuchtung von wenigstens einer an einer transparenten Scheibe vorgesehenen Schaltfläche mittels wenigstens einer Lichtquelle, wobei hinter der Schaltfläche ein Berührungsschalter angeordnet ist.

Bedienblenden von Geräten, beispielsweise Backöfen oder Kochflächen, sind nach dem Stand der Technik von einer transparenten Scheibe, insbesondere aus Kunststoff, Glas oder Glaskeramik, gebildet. An der Scheibe sind Schaltflächen zum manuellen Schalten von Funktionen des Geräts vorgesehen. An der der Schaltfläche abgewandten, hinteren Seite der Scheibe ist bei jeder Schaltfläche ein Berührungsschalter angeordnet. Der Berührungsschalter hat einen Sensor, der auf eine Fingerberührung der Schaltfläche, beispielsweise optisch oder kapazitiv oder allgemein auf die Beeinflussung eines elektrischen Feldes wirkend, reagiert.

In der DE 199 07 226 A1 ist ein an einer Glaskeramikplatte angeordneter Berührungsschalter beschrieben. Dieser weist ein Sensorelement mit einer Sensorfläche und einer Leuchtanzeige auf. Die Sensorfläche ist mit einem der Form der Leuchtmittel entsprechenden Ausschnitt versehen und umgibt die Leuchtmittel. Für jede Schaltfläche bzw. jeden Berührungsschalter ist eine eigene Lichtquelle erforderlich. Die Lichtquelle ist Teil des Berührungsschalters. Der Berührungsschalter ist damit aufwändig.

Aus der EP 0 859 467 A1 ist ein Berührungsschalter mit Sensortaste bekannt. Die Sensortaste weist einen flexiblen Körper auf, in den eine lichtemittierende Diode als Leuchtmittel einsetzbar ist. Für jeden Berührungsschalter ist ein eigenes Leuchtmittel vorgesehen.

In der US 5 239 152 ist ein kapazitiver Berührungsschalter beschrieben, hinter dem eine ihn durchleuchtende Lichtquelle angeordnet ist. Einen weiteren kapazitiven Berührungsschalter beschreibt die US 5 594 222.

In der DE 199 14 304 A1 wird eine elektrochrome Kontrastplatte beschrieben, die entweder als diskrete Einheit vor dem Bildschirm angeordnet oder durch eine gemeinsame Scheibe mit der äußeren Oberfläche des Bildschirms verbunden wird, bestehend aus einem Paar transparenter Glas- oder Kunststoffscheiben, die auf jeweils einer Seite mit einer elektrisch leitfähigen Beschichtung versehen sind, und die über einen Dichtungsring auf den Seiten ihrer leitfähigen Beschichtung zusammengefügt sind.

In der EP 0 759 660 A1 wird eine Eingabevorrichtung für einen Messumformer mit einer lichtdurchlässigen Abdeckung und mit mindestens zwei Tasten, denen jeweils ein Oberflächenbereich der Abdeckung als Eingabefeld und ein Sender zugeordnet ist, der Infrarotlicht von der Unterseite her gegen das Eingabefeld richtet, beschrieben.

Aus der US 2002/149572 A ist ein flexibler kapazitiver Berührungssensor und ein Verfahren zur Herstellung einer Mehrzahl solcher Berührungssensoren bekannt. Der kapazitive Berührungssensor umfasst ein dünnes, flexibles, transparentes Isoliersubstrat. Eine dünne, flexible, transparente Schicht von Widerstandsmaterial ist auf eine Seite des Substrats aufgebracht und eine dünne, flexible, transparente druckempfindliche Schicht von haftenden Material ist auf die andere Seite des Substrats aufgebracht. Eine Mehrzahl von dünnen, flexiblen Elektroden, elektrischen Leitungen und leitfähigen Bereichen sind auf die Widerstandsschicht aufgebracht.

Aufgabe der Erfindung ist es, eine Beleuchtungseinrichtung der eingangs genannten Art vorzuschlagen, die die Schaltfunktion des Berührungsschalters nicht stört und die Verwendung von Berührungsschaltern mit eigener Beleuchtung überflüssig macht.

Erfindungsgemäß ist obige Aufgabe durch die Merkmale des Anspruchs 1 gelöst. Bei dieser Beleuchtungseinrichtung sind der Berührungsschalter und die Lichtquelle räumlich getrennt. Dadurch beeinflussen sich die Funktionen nicht gegenseitig.

Bei der beschriebenen Beleuchtungseinrichtung können verschiedene preiswerte, handelsübliche Berührungsschalter ohne Beleuchtung verwendet werden, weil die Beleuchtung über den Lichtleiter erfolgt. Der Berührungsschalter muss nicht von der Beleuchtungseinrichtung durchstrahlt werden. Die Schaltfunktion ist unabhängig von der Beleuchtungsfunktion.

Für mehrere Schaltflächen genügt eine Lichtquelle. Es muss also nicht für jede zu beleuchtende Schaltfläche am zugeordneten Berührungsschalter eine eigene Lichtquelle vorgesehen sein.

Da die Beleuchtung in den Lichtleiter verlegt ist, ist eine flache Bauweise möglich. Die Streuzonen erfordern keinen zusätzlichen Bauraum.

Mit der beschriebenen Einrichtung lassen sich verschiedene Beleuchtungseffekte durch Wahl der Form der Streuzonen und/oder der Farbgestaltung der Streuzonen und/oder der Wahl der Lichtfarbe der Lichtquelle erreichen. Die Streuzonen lassen sich so gestalten, dass sie bei ausreichend transparenter Scheibe für den Benutzer auch im auf die Scheibe fallenden Licht (Auflicht) sichtbar sind, wenn die Lichtquelle abgeschaltet ist. Damit ist für den Benutzer die Lage der Schaltfläche immer sichtbar.

Die Beleuchtung kann verschiedene Funktionen haben. Sie kann ein nachts sichtbares Muster oder eine Schmuckbeleuchtung sein. Sie kann der Markierung der Lage der Schaltfläche und/oder zur Rückmeldung eines durchgeführten Schaltvorgangs und/oder zur Signalisierung des Schaltzustands und/oder in Form eines beleuchteten oder leuchtenden Symbols zur Darstellung der Funktion der Schaltfläche dienen.

Die beschriebene Beleuchtungseinrichtung kann bei Backöfen, Kochflächen oder Kochherden oder anderen Bedienfelder aufweisenden Geräten und Anlagen, wie beispielsweise Verkaufsautomaten und Aufzugssteuerungen verwendet werden. Sie kann immer dann eingesetzt werden, wenn das Bedienfeld eine transparente Scheibe, beispielsweise aus Glas oder Glaskeramik oder Kunststoff, hat. In allen Fällen verhindert die räumliche Trennung der Lichtquelle von den Berührungsschaltern eine gegenseitige Beeinflussung der Funktionen. Das Licht wird in der die Bedienblende bzw. das Bedienfeld bildenden Scheibe oder im Lichtleiter bereitgestellt. Es ist nicht durch die Art und den Aufbau der Berührungsschalter begrenzt. Die Art und der Aufbau der Berührungsschalter können frei und für ihre gewünschte Funktion optimiert gewählt werden. Die Art der Lichtquelle kann unabhängig von den Berührungsschaltern gewählt werden. Sie hat keinen Einfluss auf den Aufbau und die Funktion des Berührungsschalters. Damit sind viele Farbeffekte und/oder Helligkeitseffekte gestaltbar.

Weiterbildungen der beschriebenen Einrichtung ergeben sich aus den Unteransprüchen und der folgenden Beschreibung von Ausführungsbeispielen. In der Zeichnung zeigen:
Figur 1 einen nicht erfindungsgemäßen Teilschnitt einer Bedienblende schematisch, mit seitlich an ihrer Scheibe angeordneten Lichtquellen und an der Hinterseite der Scheibe ausgebildeter Streuzone, wobei nur ein Berührungsschalter dargestellt ist,
Figur 2 einen nicht erfindungsgemäßen Schnitt einer Bedienblende schematisch mit hinter der Scheibe angeordneter Lichtquelle,
Figur 3 einen Figur 1 entsprechenden nicht erfindungsgemäßen Schnitt, wobei die Streuzone im Innern der Scheibe gestaltet ist,
Figur 4 einen nicht erfindungsgemäßen Schnitt einer Bedienblende mit an der Scheibe angeordneten Lichtleitern,
Figur 5 ein nicht erfindungsgemäßes Beispiel mit Lichtleitfasern und
Figur 6 ein nich erfindungsgemäßes Beispiel mit Lichtleitkörpern.
Figur 7 eine Ausführung der Erfindung mit einem von einem Klebeband oder Klebefilm gebildeten Lichtleiter,
Figur 8 den Lichtleiter nach Figur 7 in Varianten mit
Figur 8a einem beidseitig klebenden Klebeband,
Figur 8b einem beidseitig klebenden Klebefilm,
Figur 8c einem einseitig klebenden Klebeband,
Figur 8d einem einseitig klebenden Klebefilm,
Figur 9 ein Klebeband oder Klebefilm mit Aussparung für die Lichtquelle in Aufsicht,
Figur 10 die Anordnung mit der Aussparung im Querschnitt,
Figur 11 eine weitere Ausführung mit überklebter Lichtquelle,
Figur 12 ein weiteres Ausführungsbeispiel in Richtung des Pfeiles XII der Fig. 13,
Figur 13 einen Schnitt längs der Linie A-A der Fig. 12 und
Figur 14 eine Explosionsdarstellung des weiteren Ausführungsbeispiels.

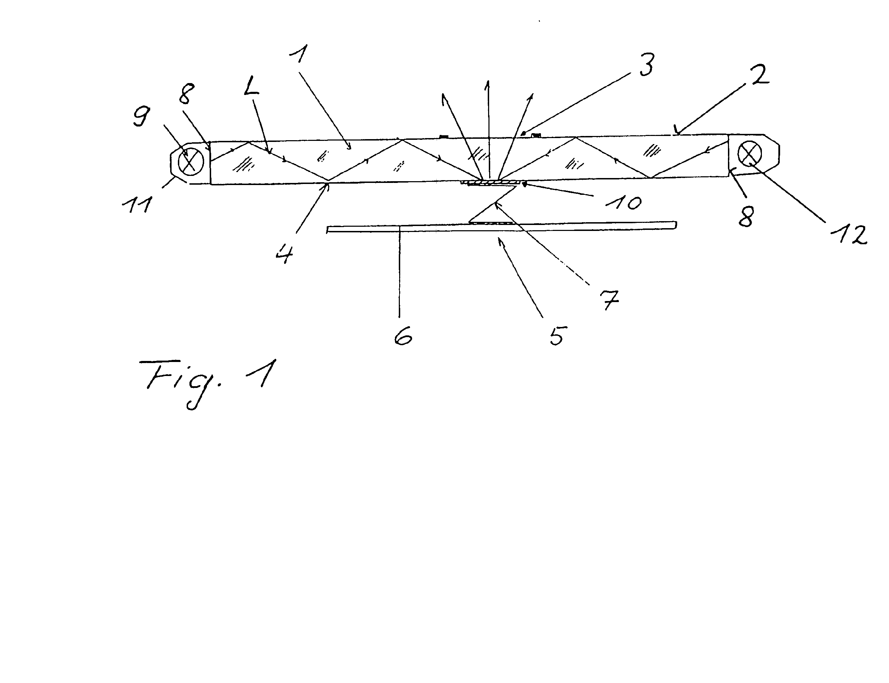

Eine Bedienblende zum Schalten elektrischer Funktionen eines Geräts weist eine Scheibe 1, beispielsweise Glaskeramikscheibe, auf. Diese kann auch gleichzeitig eine Kochfläche zur Aufstellung von Kochgeschirr bilden. Auf der Frontseite 2 der Scheibe 1 bestehen etwa fingerkuppengroße Schaltflächen 3, von denen in den Figuren 1,2,3 nur eine gezeigt ist.

An der der Frontseite 2 abgewandten Hinterseite 4 der Scheibe 1 ist gegenüber jeder Schaltfläche 3 ein Berührungsschalter 5 angeordnet. Dieser ist von einem auf einer Leiterplatte 6 angeordneten Sensor 7 in an sich bekannter Weise gebildet. Durch Fingerberührung der Schaltfläche 3 wird der Berührungsschalter 5 betätigt, wodurch er die betreffende Funktion des Geräts schaltet.

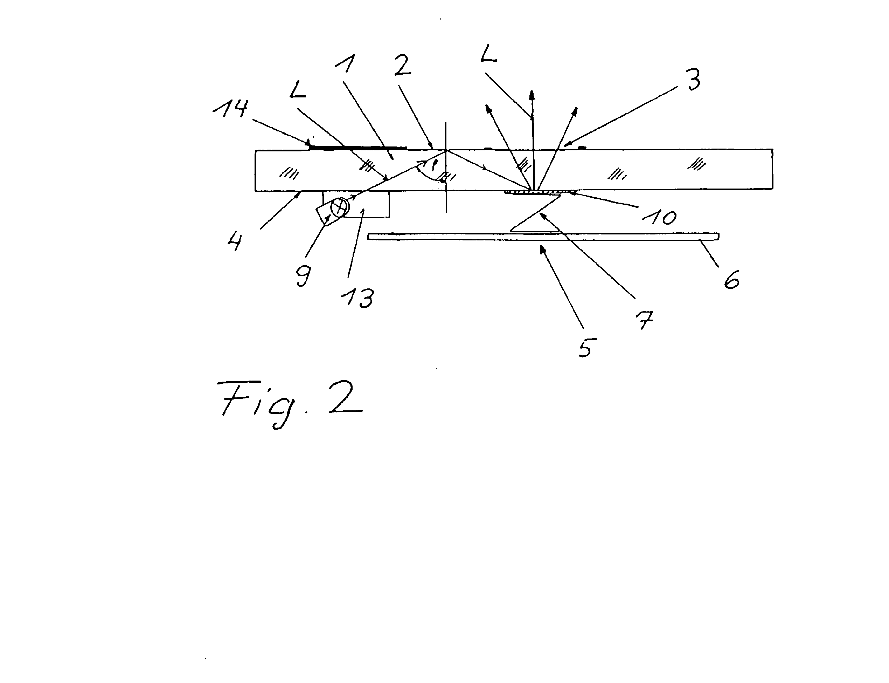

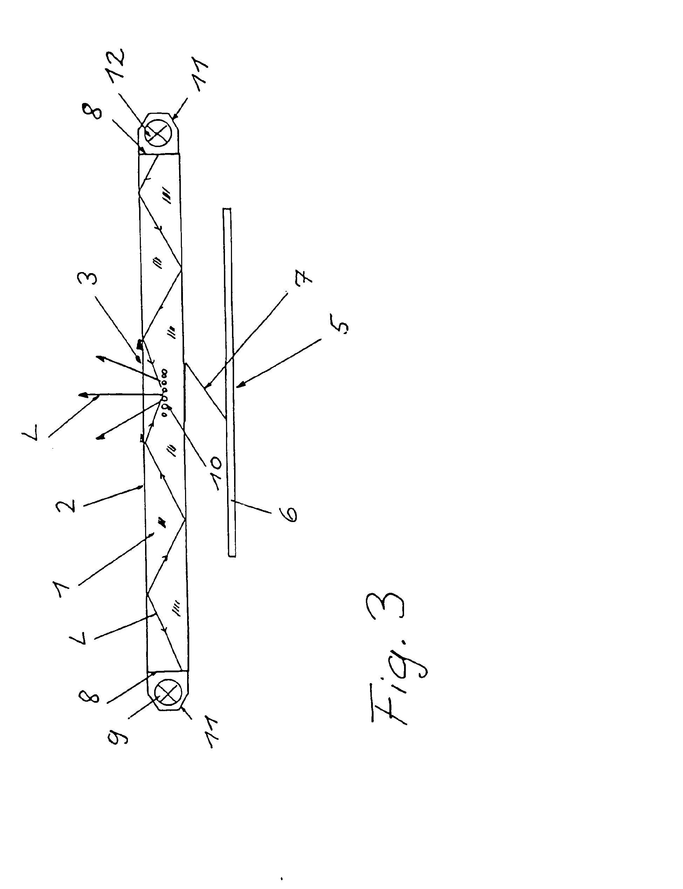

Zur Beleuchtung der Schaltfläche 3 oder der mehreren Schaltflächen ist an einem seitlichen Rand 8 (vgl. Fig. 1,3) der Scheibe 1, beabstandet von den Schaltflächen 3 eine Lichtquelle 9 angeordnet. Im Bereich jeder Schaltfläche 3 ist an der Hinterseite 4 (vgl. Fig.1, 2) oder innerhalb der Scheibe 1 (vgl. Fig.3) eine Streuzone 10 ausgebildet.

Das Licht L der Lichtquelle 9 wird am Rand 8 in die Scheibe 1 eingekoppelt und pflanzt sich in dieser unter - mehrfacher - Totalreflexion innen an der Frontseite 2 und der Hinterseite 4 fort, so dass es neben der Schaltfläche 3 nicht oder kaum austritt. Das in der Scheibe 1 durch Totalreflexion geführte Licht trifft auf die Streuzone 10 und wird an dieser derart gestreut, dass es an der Schaltfläche 3 austritt und damit diese gegenüber der Umgebung hell erscheinen lässt.

Um Reflexionsverluste am Rand 8 zu minimieren, wird das Licht der Lichtquelle 9 in einem möglichst stumpfen Winkel auf den Rand 8 gelenkt. Um zu erreichen, dass das Licht der Lichtquelle 9 möglichst überwiegend in die Scheibe 1 eintritt, kann an der dem Rand 8 abgewandten Seite der Lichtquelle 9 eine Verspiegelung 11 vorgesehen werden.

Bei den Beispielen der Figuren 1 und 3 ist eine zweite Lichtquelle 12 an der Scheibe 1 dargestellt. Diese strahlt wie die erste Lichtquelle 9 in die Scheibe 1. Sie kann eine andere Farbe oder Helligkeit als die Lichtquelle 9 aufweisen und getrennt von der Lichtquelle 9, beispielsweise in Abhängigkeit von der Betätigung des Berührungsschalters 5, schaltbar sein.

Die nach den Figuren 1 und 2 an der Hinterseite 4 der Scheibe 1 gestaltete Streuzone 10 kann von einer Gravur oder einer Mattierung der Hinterseite 4 oder einer einfarbigen oder mehrfarbigen Bedruckung der Hinterseite 4 gebildet sein. Die Streuzone 10 kann die Form eines Musters oder Symbols, beispielsweise Ziffer, Buchstaben oder sonstigen auf die mittels der betreffenden Schaltfläche zu schaltenden Funktionen hinweisenden Symbols, haben.

Beim Beispiel nach Figur 2 ist die Lichtquelle 9 seitlich beabstandet von der Schaltfläche 3 an der Hinterseite 4 der Scheibe 1 angeordnet. Der Einfallswinkel des Lichtes L ist dabei so gewählt, dass es innerhalb der Scheibe 1 zur Totalreflexion kommt. Damit nicht Totalreflexion schon beim Einkoppeln des Lichtes in die Scheibe 1 auftritt, kann die Lichtquelle 9 mittels eines Mediums 13 an die Scheibe 1 optisch angekoppelt werden. Das Medium 13 weist einen gleichen oder ähnlichen Brechungsindex wie die Scheibe 1 selbst auf. Wird beispielsweise eine LED als Lichtquelle 9 verwendet, dann kann diese mit Hilfe eines Epoxydharz-Klebstoffes an der Hinterseite 4 angeklebt werden. Weitere Möglichkeiten, das Licht von der Hinterseite 4 der Scheibe 1 unter ausreichend großen Winkeln in die Scheibe 1 einzukoppeln, bestehen in der Verwendung von optischen Vorrichtungen, wie beispielsweise Diffusor, optisches Gitter, Prismen, Spiegel.

Die Lichtquelle 9 der Figur 2 lässt sich durch eine auf der Frontseite 2 angebrachte Bedruckung 14 so abdecken, dass für den Benutzer die Lichtquelle 9 unsichtbar ist.

Beim Beispiel nach Figur 3 ist die Streuzone 10 innerhalb der Scheibe 1 gestaltet. Eine solche innenliegende Streuzone 10 lässt sich mittels eines an sich bekannten Verfahrens herstellen. Bei einem solchen Verfahren werden mit Hilfe eines Lasers im Material der Scheibe 1 gezielt Störstellen erzeugt, die eine Streuzone bilden. Dieses Verfahren ermöglicht es, bei hinreichender Wandstärke der Scheibe 1, in dieser Streuzonen in Form dreidimensionaler Symbole zu erzeugen.

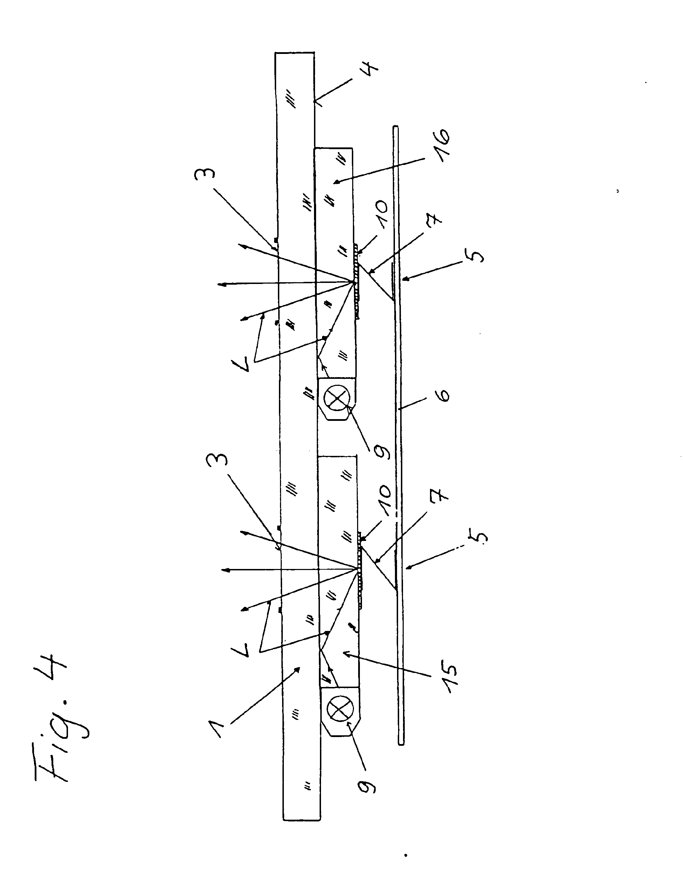

Beim Beispiel nach Figur 4 sind zwischen der Hinterseite 4 der Scheibe 1 und den Sensoren 7 der Berührungsschalter 5 mehrere separate Lichtleiter 15,16 angeordnet, die jeweils einer Schaltfläche 3 oder einer Gruppe von Schaltflächen 3 zugeordnet sind. Die Lichtleiter 15,16 sind jeweils von einer oder mehreren an ihrem Rand, seitlich beabstandet von den Schaltflächen 3 angeordneten Lichtquellen 9 beleuchtet. Die Streuzonen 10 sind, wie oben beschrieben, an oder in den Lichtleitern 15,16 derart ausgebildet, dass im jeweiligen Lichtleiter 15,16 geführtes Licht an den zugeordneten Schaltflächen 3 austritt. Dadurch lassen sich diese gleichzeitig hinsichtlich der Farbe und/oder Helligkeit unterschiedlich beleuchten. Die Lichtleiter 15,16 könnten auch durch eine einzige zentral angeordnete Lichtquelle beleuchtet sein. Deren Licht wird dabei mittels Lichtleitfasern aus Glas oder Kunststoff zu den Lichtleitern 15 und 16 geführt.

Durch die beschriebene Einrichtung sind die verschiedensten Beleuchtungseffekte erreichbar. Es können gleichmäßig flächige Beleuchtungen der Schaltfläche 3 oder an den Schaltflächen 3 erscheinende Symbole erreicht werden. Die Farbe der Beleuchtung lässt sich durch Wahl der Farbe des von der Lichtquelle 9 eingestrahlten Lichts und durch die Wahl der Eigenfarbe der Scheibe 1 oder durch die Wahl der Farbe der Streuzone 10 variieren. Dies ermöglicht verschiedene Farbeffekte. Beispielsweise kann im Ausschaltzustand des Berührungsschalters 5 die Schaltfläche 3 grün und im Einschaltzustand rot leuchten, wodurch für den Benutzer der Schaltzustand erkennbar ist. Bewirkt ein Schaltvorgang eine stufenweise Änderung, beispielsweise Leistungsverstellung eines Elements, beispielsweise Kochstelle des Geräts, so kann in Abhängigkeit von der eingestellten Leistung die Helligkeit der Lichtquelle 9 variiert werden, so dass der Benutzer die eingestellte Leistungsstufe erkennen kann. Die Schaltfläche 3 kann auch von zwei oder mehreren verschiedenfarbigen Lichtquellen 9 beleuchtet werden, deren Helligkeitsverhältnis in Abhängigkeit von der Leistungseinstellung variiert. Dadurch kann ein kontinuierlicher Übergang von einer Farbe des "Aus-Zustandes" zu einer anderen, der Maximalleistung zugeordneten Farbe, mit unterschiedlichen Mischfarben im Zwischenbereich erreicht werden.

Ist die Streuzone 10 von einem Farbaufdruck gebildet, der ein Symbol oder eine Fläche sein kann, lassen sich ebenfalls Farbeffekte erzielen. So kann beispielsweise, wenn die Scheibe 1 klar ist und die Lichtquelle 9 weisses Licht abstrahlt, die Schaltfläche 3 entsprechend der verwendeten Farben beleuchtet erscheinen. Wird eine farbiges Licht abstrahlende Lichtquelle 9 verwendet, sind in Verbindung mit unterschiedlichen Farben des Farbaufdrucks der Streuzone 10 eine Vielzahl von Farbeffekten darstellbar. Wird ein Farbaufdruck für die Streuzone 10 bei einer Kombination von beispielsweise gelbem Hintergrund mit blauem Symbol verwendet, so werden bei der Beleuchtung mit weißem Licht diese Farben dargestellt. Bei Beleuchtung mit blauem Licht jedoch kommt die Farbe blau stärker zur Geltung, während der gelbbedruckte Bereich weißlich leuchtet. Strahlt die Lichtquelle 9 rotes Licht aus, bleibt der blaubedruckte Bereich weitestgehend dunkel, wogegen der gelbbedruckte Bereich orange leuchtet.

Die Lichtquellen 9, insbesondere Leuchtdioden, lassen sich auf der die elektrische Schaltung der Berührungsschalter 5 tragenden Leiterplatte 6 mechanisch anordnen und elektrisch anschließen.

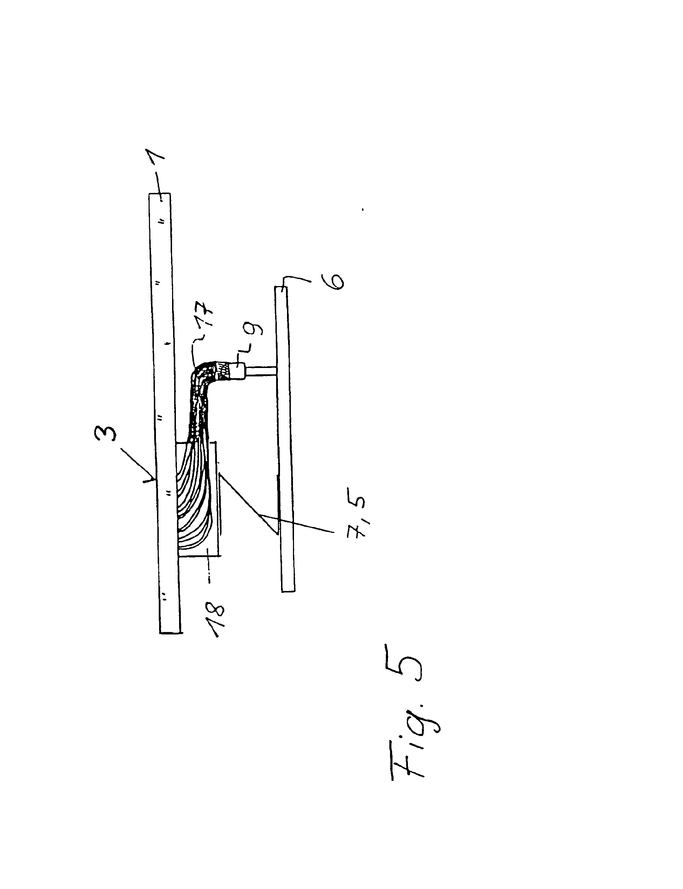

Auch beim Beispiel nach Figur 5 ist die Lichtquelle 9 auf der Leiterplatte 6 neben dem Berührungsschalter 5 angeordnet. Das Licht der Lichtquelle 9 ist mittels eines Bündels 17 von Lichtleitfasern zur Schaltfläche 3 geführt. Bei der Scheibe 1 sind die Enden der Lichtleitfasern zur Vergleichmäßigung der Beleuchtung der Schaltfläche 3 aufgefächert in einen Block 18, beispielsweise aus Kunststoff oder Wachs, eingegossen. Der Block 18 ist über dem Sensor 7 des jeweiligen Berührungsschalters 5 angeordnet und liegt auf diesem auf. Eine besondere Streuzone erübrigt sich hier.

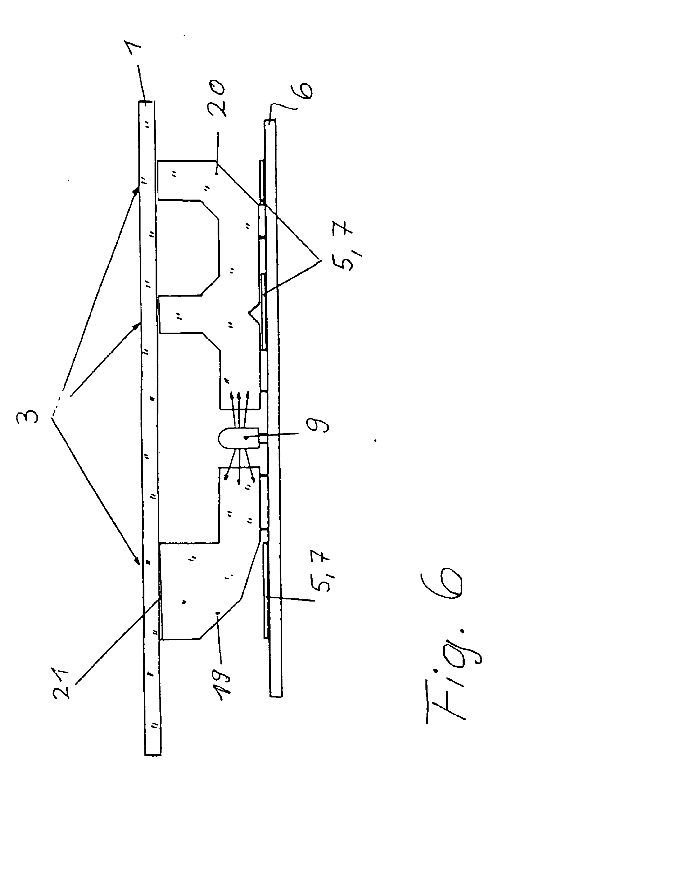

Auch beim Beispiel nach Figur 6 erübrigt sich die Gestaltung einer besonderen Streuzone. Es sind zwei dreidimensional geformte Lichtleitkörper 19,20 dargestellt, die das Licht durch ihre räumliche Gestaltung von der Lichtquelle 9 zu den über den Berührungsschaltern 5 liegenden Schaltflächen 3 lenken. Die Berührungsschalter 5 wirken auf eine, speziell durch eine Fingerberührung erfolgende Beeinflussung des elektrischen Feldes. Der Lichtleitkörper 19,20 liegt auf dem Sensor 7 des jeweiligen Berührungsschalters 5 auf. Auf derjenigen Oberfläche 21 des Lichtleitkörpers 19 bzw. 20, an der das Licht zur jeweiligen Schaltfläche 3 ausgekoppelt wird, können die Funktion des jeweiligen Berührungsschalters 5 symbolisierende Zeichen angeordnet sein, die das Licht abschatten, um das Zeichen für den Benutzer sichtbar zu machen. Alternativ kann der Lichtleitkörper 19 bzw. 20 an der Austrittsstelle des Lichts die Form eines entsprechenden Symbols haben.

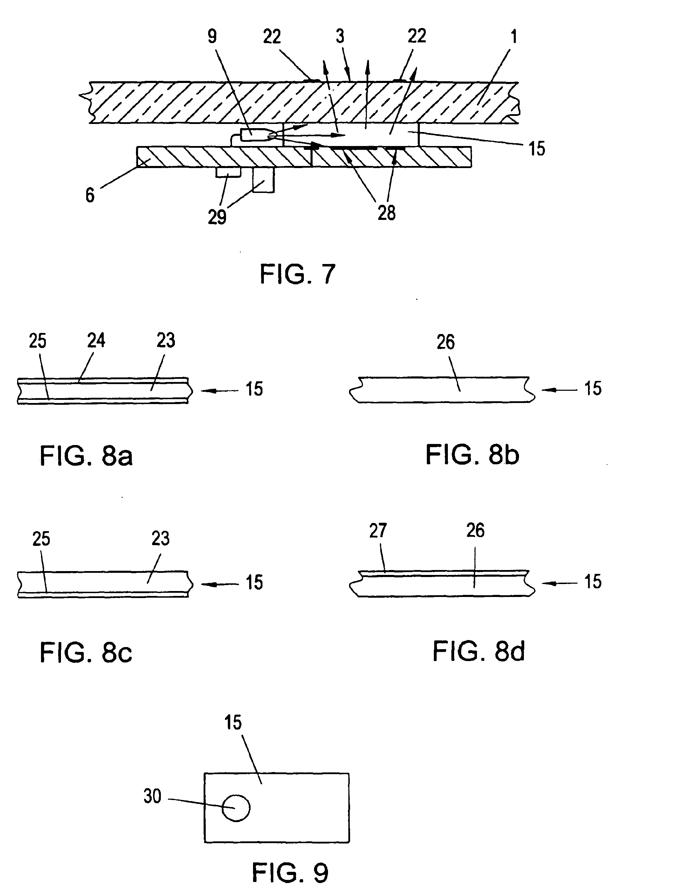

Die Figuren 7 bis 11 zeigen eine einfach und preiswert herstellbare und montierbare Gestaltung der Anordnung. Der Lichtleiter 15 ist von einem transparenten Klebeband geeigneter Dicke gebildet. Das Licht der Lichtquelle 9 wird in das Klebeband eingekoppelt und bei der Schaltfläche 3 ausgekoppelt, die von einer Markierung 22 begrenzt ist. Das Klebeband kann als Meterware oder als vorgefertigtes Stanzteil verarbeitet werden. Die Dicke des Klebebandes beträgt beispielsweise 0,5 mm bis 5 mm, insbesondere 1 mm bis 2 mm.

Nach den Figuren 8a und 8c weist das Klebeband einen transparenten Träger 23 auf, der beidseitig (vgl. Fig. 8a) oder einseitig (Fig. 8c) einen transparenten Klebefilm 24,25 trägt.

Nach Figur 8b und Figur 8d ist das Klebeband von einem durchgängigen Klebefilm 26 gebildet. Als durchgängiger Klebefilm eignet sich ein Acrylat-Klebeband, wie es beispielsweise als Scotch VHB-Produkt der Fa. 3M bezogen werden kann; beispielsweise ist das unter dem Handelsnamen Scotch Isotac erhältliche Klebeband geeignet. Das Material zeichnet sich durch eine hohe Transparenz sowie Alterungs- und Temperaturbeständigkeit bei guten Klebeeigenschaften aus und ist in unterschiedlichen Dicken als Meterware oder als Formstanzteil erhältlich. Es kann beidseitig klebend oder einseitig laminiert bezogen werden.

Ein einseitig klebendes Klebeband lässt sich bei der Montage auf die Leiterplatte 6 oder an die Scheibe 1, die Bedienblende ist, ankleben. Ein beidseitig klebendes Klebeband erlaubt es, die Leiterplatte 6 mit der Scheibe 1 zu verkleben. Für die doppelseitige Verklebung weist der transparente Träger 23 beidseitig Klebefilme 24,25 auf (vgl. Fig. 8a). Der Klebefilm 26 klebt ohnehin beidseitig (vgl. Fig. 8b). Für die einseitige Verklebung weist der Träger 23 nur einseitig einen Klebefilm 24 auf (vgl. Fig. 8c). Der Klebefilm 26 ist, wenn nur eine einseitige Verklebung vorgesehen ist, an seiner anderen Seite mit einer nichtklebenden transparenten Deckfolie 27 versehen (vgl. Fig. 8d). Die Figuren 8c und 8d zeigen den Fall, in dem das Klebeband mit der Leiterplatte 6 verklebt werden soll.

Um eine Beeinflussung der an der Schaltfläche 3 sichtbaren Lichtfarbe durch die Eigenfarbe der meist grünen Leiterplatte 6 zu vermeiden, kann die Leiterplatte 6 im Bereich des Lichtleiters 15 bzw. 16 weiß oder in einer gewünschten Farbe gestaltet sein. Dies kann beispielsweise durch eine entsprechende Bedruckung der Leiterplatte 6 oder durch das Aufkleben eines weißen oder farbigen weiteren Klebebandes als Zwischenschicht zwischen der Leiterplatte 6 und dem als Lichtleiter dienenden Klebeband erfolgen. Statt des zusätzlichen weißen oder farbigen Klebebandes kann bei den Beispielen der Figuren 8a und 8c der Klebefilm 25 weiß oder farbig oder wenigstens nichttransparent sein. Diese Schicht kann die Funktion der Streuzone 10 übernehmen.

Die Figuren 7, 10 und 11 zeigen die Anordnung einer als Lichtquelle 9 dienenden lichtemittierenden Diode und als Sensor 7 dienenden Elektroden 28 und für den Berührungsschalter 5 nötigen elektronischen Bauelementen 29 an der Leiterplatte 6.

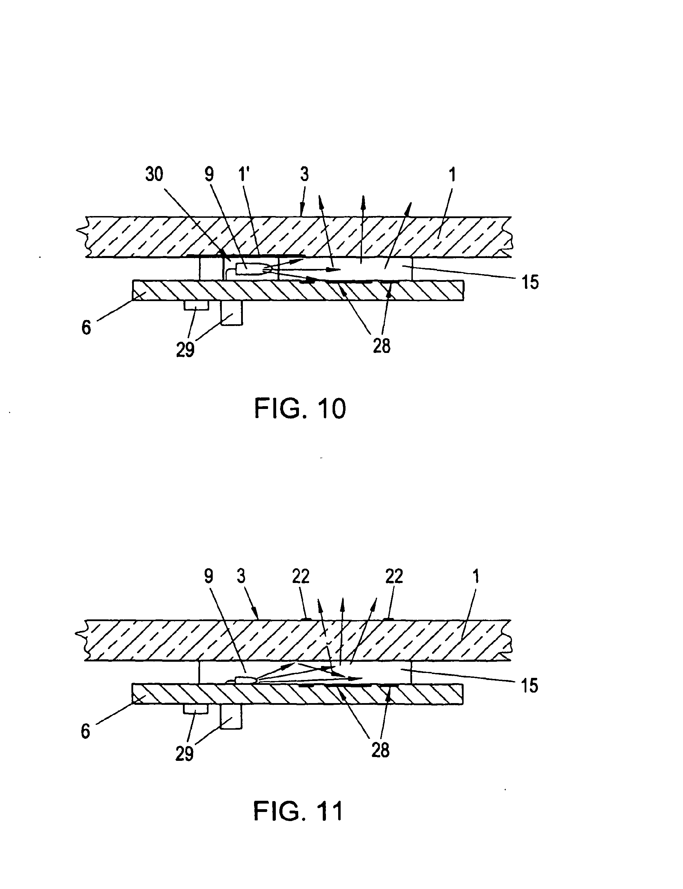

Bei der Ausführung nach Figur 7 ist die Lichtquelle 9 seitlich neben dem den Lichtleiter 15 bildenden Klebeband angeordnet. Bei der Ausführung nach den Figuren 9 und 10 weist das transparente Klebeband eine Aussparung 30 auf, in die die Lichtquelle 9 ragt. Bei der Ausführung nach Figur 11 ist die Lichtquelle 9 - insbesondere als in SMD (Surface Mounting Device)-Technik flachbauend, seitlich abstrahlend gestaltet - mit dem als Lichtleiter 15 wirkenden transparenten Klebeband überklebt. Dafür ist das Klebeband vorzugsweise weich und hinreichend dick.

Um die Lichtquelle 9 für den Nutzer unsichtbar zu machen, kann über die Lichtquelle 9 eine Bedruckung 1' der Hinterseite 4 der Scheibe 1 vorgesehen sein (vgl. Fig. 10).

Zur Verbesserung der Lichtstreuung im Bereich der Schaltfläche 3 ist es möglich, ein Klebeband zu verwenden, in dem Streuzentren, beispielsweise in Form kleiner Glaskugeln, integriert sind. Es erübrigen sich dann zusätzlich Streuzonen.

Aus den beschriebenen Teilmerkmalen ergeben sich zahlreiche weitere Ausführungsbeispiele. Es kann zur Verbesserung der Lichtleitung vorgesehen sein, die Scheibe 1 oder die Leiterplatte 6 als Lichtleiter mit optisch dichterem Kern zu gestalten. Die Lichtquelle 9 kann auch hinter dem Berührungsschalter 5 angeordnet sein. Der Lichtleiter 15,16 oder das Bündel 17 der Lichtleitfasern oder die Lichtleitkörper 19,20 sind dann so gestaltet, dass sie das Licht um den bzw. die Berührungsschalter 5 herum zu der/den Schaltflächen 3 lenken.

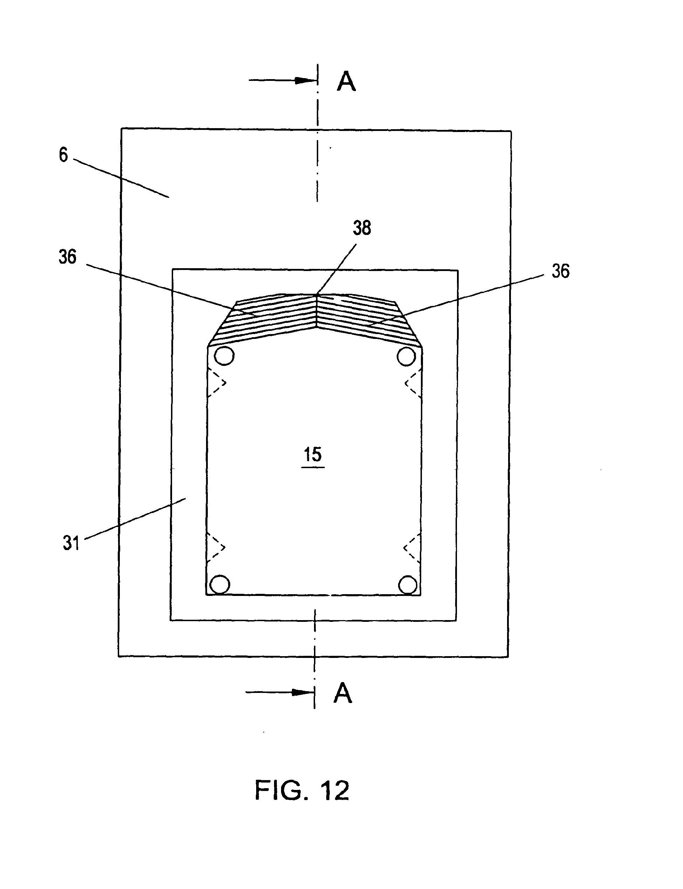

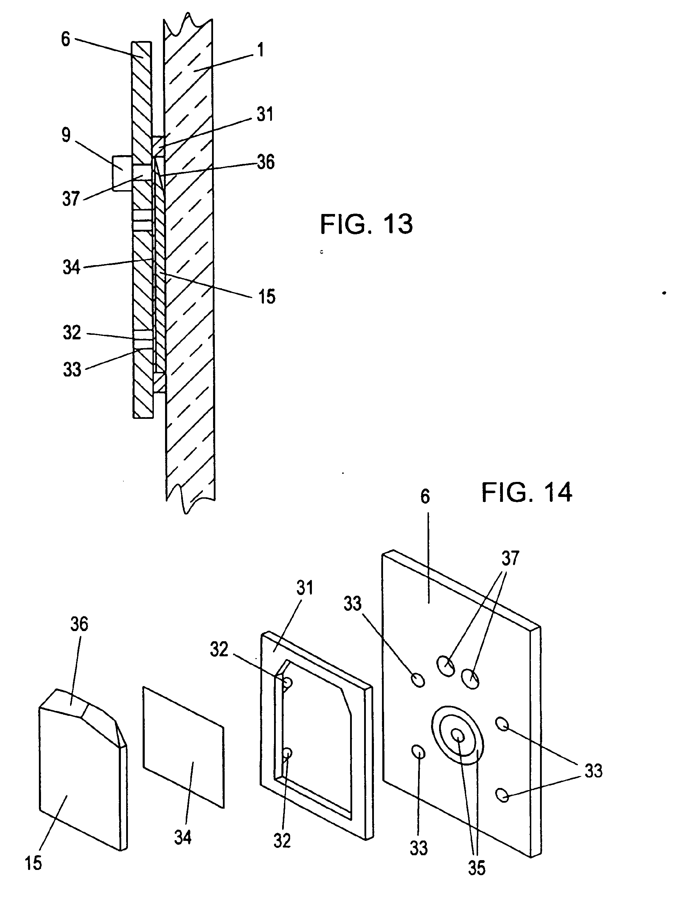

Beim Ausführungsbeispiel nach den Figuren 12 bis 14 ist der plattenförmige Lichtleiter 15 in einen Rahmen 31 geschnappt. Der Rahmen 31 besitzt Keilstifte 32, die in Öffnungen 33 der Leiterplatte 6 klemmend eindrückbar sind.

Zwischen dem Lichtleiter 15 und der Leiterplatte 6 ist eine elektrisch nichtleitende, beispielsweise weiße oder silbrige, Reflektorfolie 34 angeordnet. Diese deckt die auf der Leiterplatte 6 angeordneten Elektroden 35 des Sensors 7 und die Leiterplatte 6 ab und streut Lichtstrahlung in Richtung der Schaltflächen 3.

Der Lichtleiter 15 weist eine geriffelte oder glatte Randschräge 36 auf, die von einem Ansatz des Rahmens 31 überdeckt sein kann. Bei der Randschräge 36 ist wenigstens einer Durchbrechung 37 der Leiterplatte 6 vorgesehen, in der die Lichtquelle 9, beispielsweise eine lichtemittierende Diode, sitzt, oder durch die sie in den Lichtleiter 15 strahlt. Die Randschräge 36 lenkt das Licht der Lichtquelle 9 in dem Lichtleiter 15 um. Durch die Überdeckung der Randschräge 36 ist die Lichtquelle 9 für den Nutzer unsichtbar.

Sind zwei oder mehrere Lichtquellen vorgesehen, dann lässt sich bei Verschiedenfarbigkeit der Lichtquellen ein Farblichtmischeffekt erreichen.

Der Lichtleiter 15 kann sich über eine oder mehrere Schaltflächen 3 erstrecken. Erstreckt er sich über mehrere Schaltflächen, dann können diese für den Nutzer optisch erkennbar durch eine Bedruckung oder sonstige Beschichtung des Lichtleiters 15 oder der Scheibe 1 begrenzt sein.

Die Randschräge 36 weist eine Knickung 38 auf, die bei den im Ausführungsbeispiel der Figuren 12 bis 14 vorgesehenen zwei beabstandeten Lichtquellen 9 die Lichtverteilung im Lichtleiter 15 verbessert.

Der Rahmen 31 kann in der Weise lichtreflektierend gestaltet sein, dass er Licht aus dem Lichtleiter 15 in diesen zurück reflektiert. Entsprechend können auch die Ränder des aus Glas oder Kunststoff bestehenden Lichtleiters 15 lichtreflektierend beschichtet oder gestaltet sein.

Bei den Ausführungsbeispielen sind die Lichtquellen 9 und die Sensoren 7 der Berührungsschalter 5 räumlich getrennt, wodurch eine gegenseitige Beeinflussung der Funktionen verhindert ist. Die unter den Schaltflächen 3 liegenden Zonen der Lichtleiter 15,16,17,19,20 können als Symbole gebildet sein oder Symbole tragen, die beispielsweise die Funktion des jeweils zugeordneten Berührungsschalters 5 charakterisieren.

## Patentansprüche

1. Einrichtung zur Beleuchtung von wenigstens einer auf einer transparenten Scheibe, insbesondere Kunststoff-, Glas- oder Glaskeramikscheibe, vorgesehenen Schaltfläche mittels wenigstens einer Lichtquelle und wenigstens einem Lichtleiter (15,16,17,19,20), wobei hinter der Schaltfläche ein Berührungsschalter angeordnet ist, wobei die Lichtquelle (9) beabstandet von der Schaltfläche (3) angeordnet ist, die Lichtquelle (9) in den an der Scheibe (1) angeordneten Lichtleiter (15,16,17,19,20) strahlt und ihr Licht in dem Lichtleiter (15,16,17,19,20) in Richtung der Schaltfläche (3) geführt ist und das Licht in den zwischen der Schaltfläche (3) und dem Sensor (7) des Berührungsschalters (5) liegenden Bereich eingeführt ist, **dadurch gekennzeichnet, dass** der Lichtleiter (15) von einem transparenten Klebeband gebildet ist, welches mit der Scheibe (1) und/oder einer die Lichtquelle (9) tragenden Leiterplatte (6) verklebt ist.

2. Einrichtung nach Anspruch 1, **dadurch gekennzeichnet, dass** im Bereich der Schaltfläche (3) an oder in der Scheibe (1) oder dem Lichtleiter (15,16) eine Streuzone (10) ausgebildet ist, die das Licht zur Schaltfläche (3) hin auskoppelt.

3. Einrichtung nach Anspruch 2, **dadurch gekennzeichnet, dass** im Wege der Lichtführung zwischen der Lichtquelle (9) und der Streuzone (10) Totalreflexion stattfindet.

4. Einrichtung nach einem der vorhergehenden Ansprüche,
**dadurch gekennzeichnet,**
**dass** jeder Schaltfläche (3) oder einer Gruppe von Schaltflächen (3) ein eigener Lichtleiter (15,16,17,19,20) zugeordnet ist.

5. Einrichtung nach einem der vorhergehenden Ansprüche,
**dadurch gekennzeichnet,**
**dass** bei der Lichtquelle (9) die Scheibe (1) eine Bedruckung (14) zur optischen Abdeckung der Lichtquelle (9) aufweist.

6. Einrichtung nach einem der vorhergehenden Ansprüche,
**dadurch gekennzeichnet,**
**dass** die Lichtquellen (9) unterschiedliche Lichtfarben abstrahlen und/oder dass die Helligkeiten der Lichtquellen (9) unterschiedlich sind oder die Helligkeit der Lichtquelle (9) oder der Lichtquellen (9) verstellbar ist.

7. Einrichtung nach einem der Ansprüche 2 bis 6, **dadurch gekennzeichnet,**
**dass** die Streuzone (10) von einer Gravur, Mattierung oder Bedruckung der der Schaltfläche (3) abgewandten Hinterseite (4) der Scheibe (1) oder des Lichtleiters (15,16) gebildet ist und/oder dass die die Streuzone (10) bildende Bedruckung zweifarbig oder mehrfarbig ist.

8. Einrichtung nach einem der Ansprüche 2 bis 7, **dadurch gekennzeichnet,**
**dass** die Streuzone (10) derart gestaltet ist, dass sie auch bei abgeschalteter Lichtquelle (9) sichtbar ist.

9. Einrichtung nach Anspruch 1,
**dadurch gekennzeichnet,**
**dass** das transparente Klebeband aus einem transparenten Träger (23), der einseitig oder beidseitig einen Klebefilm (24,25) trägt, besteht oder dass das transparente Klebeband von einem durchgängigen Klebefilm (26) gebildet ist.

10. Einrichtung nach Anspruch 9,
**dadurch gekennzeichnet,**
**dass** der Klebefilm (26) einseitig mit einer nichtklebenden Deckfolie (27) versehen ist.

11. Einrichtung nach einem der vorhergehenden Ansprüche 9 bis 10,
**dadurch gekennzeichnet,**
**dass** die Lichtquelle (9) in eine Aussparung (30) des Klebebandes ragt oder mit diesem überklebt ist.

12. Einrichtung nach einem der vorhergehenden Ansprüche,
**dadurch gekennzeichnet,**
**dass** zwischen dem Lichtleiter (15) und einer die Lichtquelle (9) tragenden Leiterplatte (6) eine nichttransparente oder weiße oder farbige Schicht (34) angeordnet ist.

13. Einrichtung nach einem der vorhergehenden Ansprüche,
**dadurch gekennzeichnet,**
**dass** der Lichtleiter (15) in einem Rahmen (31) sitzt, der an der Leiterplatte (6) befestigt ist.

14. Einrichtung nach einem der vorhergehenden Ansprüche,
**dadurch gekennzeichnet,**
**dass** die Lichtleiter (15,16) von einer gemeinsamen Lichtquelle (9) beleuchtet sind, deren Licht mittels Lichtleitfasern zu den Lichtleitern (15,16) geführt ist.

## Claims

1. Device for illuminating at least one switch surface on a transparent panel, in particular a plastic, glass or glass ceramic panel, by at least one light source and at least one light conductor (15, 16, 17, 19, 20), wherein behind the switch surface a touch sensor switch is arranged, wherein the light source (9) is arranged at a distance from the switch surface (3), the light source (9) emitting into the light conductor (15, 16, 17, 19, 20) being arranged on the panel and the light is conducted in the light conductor (15, 16, 17, 19, 20) towards the switch surface (3) and the light is conducted into an area between the switch surface (3) and the sensor element (7) of the touch sensor switch (5), **characterized in that** the light conductor (15) is formed by a transparent adhesive strip, which is adhered to the panel (1) and/or a light source (9) comprising conductor board (6).

2. Device according to claim 1, wherein in the area of the switch surface (3) at or in the panel (1) or the light conductor (15, 16) a dispersion zone is formed, which uncouples the light towards the switch surface (3).

3. Device according to claim 2, wherein in the way of light radiation between the light source (9) and the dispersion zone (10) total reflectance occurs.

4. Device according to one of the preceding claims, wherein a light conductor (15, 16, 17, 19, 20) is assigned to every switch surface (3) or to a group of switch surfaces (3).

5. Device according to one of the preceding claims, wherein at the light source (9) the panel (1) has an imprinting (14) as an optical covering of the light source (9).

6. Device according to one of the preceding claims, wherein the light sources (9) emit different light colours and/or the luminance of the light sources (9) are different or the luminance of the light source (9) or the light sources (9) is adjustable.

7. Device according to one of the preceding claims 2 to 6, wherein the dispersion zone (10) is composed of an engraving, matting or imprinting of the back side (4) of the panel (1) turned away of the switch surface (3) or of the light conductor (15, 16) and/or the imprinting forming the dispersion zone (10) is two or multi coloured.

8. Device according to one of the preceding claims 2 to 7, wherein the dispersion zone (10) is designed in such a way, that it is also visible when the light source (9) is switched off.

9. Device according to claim 1, wherein the transparent adhesive tape consists of a transparent carrier (23), which has an one-sided or two-sided adhesive film (24, 25) or the transparent adhesive tape is formed of a continuous adhesive film (26).

10. Device according to claim 9, wherein the adhesive film (26) is one-sided provided with a non adhesive cover film (27).

11. Device according to one of the preceding claims 9 to 10, wherein the light source (9) projects into a space (30) of the adhesive tape or is covered with it.

12. Device according to one of the preceding claims, wherein between the light conductor (15) and the the light source (9) comprising conductor board (6) a non-transparent or white or coloured layer (34) is arranged.

13. Device according to one of the preceding claims, wherein the light conductor (15) is located in a frame (31), which is mounted at the conductor board (6).

14. Device according to one of the preceding claims, wherein the light conductors (15, 16) are illuminated by a common light source (9), whose light is conducted to the light conductors (15, 16) using optical fibres.

## Revendications

1. Dispositif d'éclairage d'au moins un bouton de commande prévu sur une vitre transparente, en particulier une vitre synthétique, en verre ou vitrocéramique, au moyen d'une source lumineuse au moins et d'un conducteur de lumière au moins (15, 16, 17, 19, 20), un commutateur sensitif étant monté derrière le bouton de commande, la source lumineuse (9) étant disposée à distance du bouton de commande (3), la source lumineuse (9) rayonnant dans le conducteur de lumière (15, 16, 17, 19, 20) disposé sur la vitre (1) et sa lumière étant guidée dans le conducteur de lumière (15, 16, 17, 19, 20) dans le sens du bouton de commande (3) et étant engagée dans la zone située entre le bouton de commande (3) et le capteur (7) du commutateur sensitif (5) **caractérisé en ce que** le conducteur de lumière (15) est constitué d'une bande adhésive transparente qui est collée à la vitre (1) et/ou à un circuit imprimé (6) portant la source lumineuse (9).

2. Dispositif selon la revendication 1,
**caractérisé en ce que**
une zone de dispersion (10) qui découple la lumière dans la direction du bouton de commande (3) est constituée dans la zone du bouton de commande (3), sur ou dans la vitre (1) ou le conducteur de lumière (15, 16).

3. Dispositif selon la revendication 2,
**caractérisé en ce que**
il y a une réflexion totale sur le parcours du guidage de la lumière entre la source lumineuse (9) et la zone de dispersion (10).

4. Dispositif selon l'une quelconque des revendications précédentes,
**caractérisé en ce que**
à chaque bouton de commande (3) ou à un groupe de boutons de commande (3), est affecté un conducteur de lumière (15, 16, 17, 19, 20) propre.

5. Dispositif selon l'une quelconque des revendications précédentes,
**caractérisé en ce que**
près de la source lumineuse (9), la vitre (1) comporte une impression (14) pour le recouvrement optique de la source lumineuse (9).

6. Dispositif selon l'une quelconque des revendications précédentes,
**caractérisé en ce que**
les sources lumineuses (9) émettent des couleurs différentes et/ou que la luminosité des sources lumineuse (9) est différente ou que la luminosité de la source lumineuse (9) ou des sources lumineuses (9) est réglable.

7. Dispositif selon l'une quelconque des revendications 2 à 6,
**caractérisé en ce que**
la zone de dispersion (10) est réalisée par gravure, dépolissage ou impression de la face arrière (4) de la vitre (1) opposée au bouton de commande (3) ou du conducteur de lumière (15, 16) et/ou que l'impression constituant la zone de dispersion (10) est bicolore ou multicolore.

8. Dispositif selon l'une quelconque des revendications 2 à 7,
**caractérisé en ce que**
la zone de dispersion (10) est conformée de telle manière qu'elle est visible même avec la source lumineuse (9) déconnectée.

9. Dispositif selon la revendication 1,
**caractérisé en ce que**
la bande adhésive transparente est constituée d'un support (23) transparent portant un film adhésif (24, 25) sur une face ou deux faces ou que la bande adhésive transparente se compose d'un film adhésif (26) continu.

10. Dispositif selon la revendication 9,
**caractérisé en ce que**
le film adhésif (26) est muni, d'un côté, d'une feuille de recouvrement (27) non adhésive.

11. Dispositif selon l'une quelconque des revendications précédentes 9 à 10,
**caractérisé en ce que**
la source lumineuse (9) s'engage dans un évidement (30) de la bande adhésive ou est collée sur ladite bande adhésive.

12. Dispositif selon l'une quelconque des revendications précédentes,
**caractérisé en ce que**
une couche (34) opaque ou blanche ou teintée est disposée entre le conducteur de lumière (15) et un circuit imprimé (6) portant la source lumineuse (9).

13. Dispositif selon l'une quelconque des revendications précédentes,
**caractérisé en ce que**
le conducteur de lumière (15) est logé dans un cadre (31) qui est fixé sur le circuit imprimé (6).

14. Dispositif selon l'une quelconque des revendications précédentes,
**caractérisé en ce que**
les conducteurs de lumière (15, 16) sont éclairés par une source lumineuse (9) commune dont la lumière est guidée vers les conducteurs de lumière (15, 16) au moyen de fibres optiques.
